# EUROPEAN PATENT SPECIFICATION

(11) **EP 2 506 313 B1**
(45) Date of publication and mention of the grant of the patent: **19.08.2020**
(21) Application number: 11832667.7
(22) Date of filing: 27.04.2011
(51) Int. Cl.: H01L 31/042, H01L 31/0749, H01L 31/18

(54) **METHOD FOR MANUFACTURING A SOLAR CELL**
VERFAHREN ZUR HERSTELLUNG EINER SOLARZELLE
PRÓCÉDE DE FABRICATION D'UNE CELLULE SOLAIRE

(30) Priority: 11.10.2010 KR 20100099001
(43) Date of publication of application: 03.10.2012
(73) Proprietor: LG Innotek Co., Ltd., Seoul, 04637 (KR)
(72) Inventor: BAE, Do Won, Seoul 100-714 (KR)
(74) Representative: Novagraaf Technologies
(86) International application number: PCT/KR2011/003121
(87) International publication number: WO 2012/050280

(56) References cited:
- EP-A1- 2 592 656
- CN-U- 201 562 684
- JP-A- 2005 228 975
- JP-A- 2009 170 928
- KR-A- 20080 009 346
- KR-A- 20080 009 346
- KR-A- 20100 098 008
- SUYAMA N ED - JAPAN SOCIETY OF APPLIED PHYSICS: "CDS/CDTE SOLAR CELLS BY THE SCREEN-PRINTING-SINTERING TECHNIQUE", PROCEEDINGS OF THE INTERNATIONAL PHOTOVOLTAIC SCIENCE AND ENGINEERING CONFERENCE. KYOTO, NOV. 26 - 30, 1990; [PROCEEDINGS OF THE INTERNATIONAL PHOTOVOLTAIC SCIENCE AND ENGINEERING CONFERENCE], KYOTO, KYOTO UNIVERSITY, JP, vol. CONF. 5, 26 November 1990 (1990-11-26), pages 757-760, XP000215125,
- WEBER M ET AL: "INVESTIGATION OF HYDROGEN SPECIES IN CHEMICAL BATH DEPOSITED CdS FOR THIN-FILM SOLAR CELLS", 14TH. E.C. PHOTOVOLTAIC SOLAR ENERGY CONFERENCE. BARCELONA, SPAIN, JUNE 30 - JULY 4, 1997; [PROCEEDINGS OF THE INTERNATIONAL PHOTOVOLTAIC SOLAR ENERGY CONFERENCE], BEDFORD : H. C. STEPHENS & ASSOCIATES, GB, vol. CONF. 14, 30 June 1997 (1997-06-30), pages 2164-2167, XP001136528, ISBN: 978-1-901675-03-0

## Description

### Technical Field

The disclosure relates to a method for manufacturing a solar cell.

### Background Art

Recently, as energy consumption is increased, a solar cell has been developed to convert solar energy into electrical energy.

The solar cell is classified into a silicon solar cell, a non-silicon solar cell, and a dye-sensitized solar cell. Among them, the non-silicon solar cell can be formed by using a thin film, so the non-silicon solar cell can reduce consumption of the material while diversifying the application range of the solar cell. In addition, a light absorbing layer used in the non-silicon solar cell may be rarely deteriorated by light, so the life span of the non-silicon solar cell may be lengthened.

In such a solar cell, the improvement of the photoelectric conversion efficiency is an important factor. The document JP 2005 228975 A, and the publication "CdS/CdTe Solar cells by the screen-printing-sintering technique", N. Suyama et al, Proceedings of the International Photovoltaic Science and Engineering Conference, Kyoto, Nov. 26 - 30, 1990; vol. conf. 5, 26.11.1990, p.757-760 and the publication "Investigation of hydrogen Species in Chemical Bath deposited CdS for thin-film solar cells", M. Weber et al., The International Photovoltaic Solar Energy Conference , BEDFORD : H. C. Stephens & Associates, GB, vol. conf.14, 30.06.1997, p.2164-2167 describe a method for manufacturing a solar cell and improvement of its photoelectric conversion efficiency by annealing its buffer layer.

### Disclosure

### Technical Problem

The embodiment provides a method for manufacturing a solar cell capable of improving the photoelectric conversion efficiency.

### Technical Solution

The technical problem is solved by a method for manufacturing a solar cell according to claim 1. Advantageous embodiments are described in the dependent claims. The method for manufacturing a solar cell according to the embodiment includes the steps of forming a first electrode layer on a substrate; forming a light absorbing layer on the first electrode layer; forming a buffer layer on the light absorbing layer; annealing the buffer layer to reduce an oxygen content in the buffer layer; and forming a second electrode layer on the buffer layer.

The annealing includes a rapid thermal annealing (RTA) and the annealing temperature is in a range of 250°C to 400°C. The annealing is performed in a vacuum atmosphere or a hydrogen atmosphere.

The buffer layer has the oxygen content in a range of 2 at% to 5 at% after the annealing. The buffer layer has the oxygen content of 6 at% or more before the annealing.

The buffer layer is formed through a chemical bath deposition (CBD) scheme. The buffer layer includes ZnS.

### Advantageous Effects

According to the embodiment, the oxygen content in the buffer layer can be adjusted by annealing the buffer layer, so that the recombination at the interfacial surface of the light absorbing layer can be prevented and the photoelectric conversion efficiency can be improved.

### Description of Drawings

FIG. 1 is a flowchart showing a method for manufacturing a solar cell according to the embodiment;
FIGS. 2 to 7 are sectional views showing the manufacturing steps of a method for manufacturing a solar cell according to the embodiment; and
FIG. 8 is a graph showing a relative efficiency of a solar cell as a function of an oxygen content of a buffer layer.

### Best Mode

### Mode for Invention

In the description of the embodiments, it will be understood that when a layer (film), a region, a pattern or a structure is referred to as being "on" or "under" another layer (film), another region, another pad, or another pattern, it can be "directly" or "indirectly" on the other layer (film), the other region, the other pad, or the other pattern, or one or more intervening layers may also be present. Such a position of the layer has been described with reference to the drawings.

The size or the thickness of the layer (film), the region, the pattern or the structure may be modified exaggerated for the purpose of explanation and clarity. The size may not utterly reflect the actual size.

Hereinafter, the embodiment will be described in detail with reference to accompanying drawings.

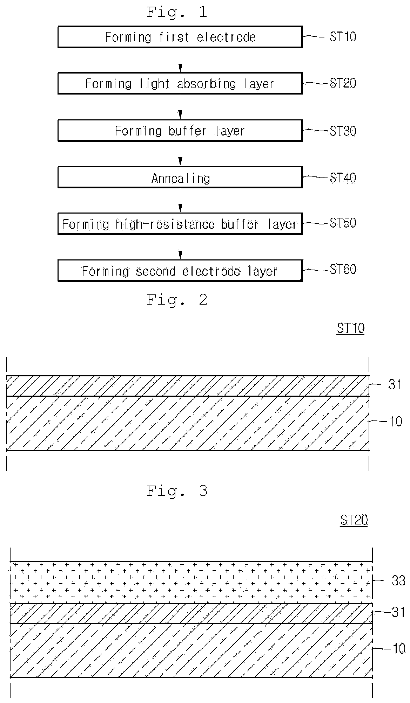

FIG. 1 is a flowchart showing a method for manufacturing a solar cell according to the embodiment, and FIGS. 2 to 7 are sectional views showing the manufacturing steps of the method for manufacturing the solar cell according to the embodiment.

Referring to FIG. 1, the method for manufacturing the solar cell according to the embodiment may include the steps of forming a first electrode layer ST10, forming a light absorbing layer ST20, forming a buffer layer ST30, performing an annealing process ST40, forming a high-resistance buffer layer ST50, and forming a second electrode layer ST60. These steps will be described in detail with reference to FIGS. 2 to 7.

First, as shown in FIG. 2, a substrate 10 is prepared and a first electrode layer 31 is formed on the substrate 10 in step ST10.

The substrate 10 has a plate shape and supports the first electrode layer 31 formed thereon. The substrate 10 may include an insulator, such as glass or plastic. In more detail, the substrate 10 may include soda lime glass. However, the embodiment is not limited thereto. For instance, the substrate 10 may include a metallic substrate. That is, the substrate 10 may be formed by using a rigid material or a flexible material according to the property of the solar cell.

The first electrode layer 31 may include various conductive materials. For instance, the first electrode layer 31 may include Mo, Cu, Ni, Al and an alloy thereof. The first electrode layer 31 can be formed through various processes. For instance, the first electrode layer 31 can be formed by depositing Mo through the sputtering process.

In addition, the first electrode layer 31 may include at least two layers. In this case, the layers may be formed by using the homogeneous metal or heterogeneous metals. The first electrode layer 31 including at least two layers can be formed by performing the process twice under the different process conditions.

According to the drawing, the first electrode layer 31 is directly formed on the substrate 10, but the embodiment is not limited thereto. For instance, a diffusion barrier layer (not shown) may be formed between the substrate 10 and the first electrode layer 31.

Then, as shown in FIG. 3, a light absorbing layer 33 is formed on the first electrode layer 31 in the step of forming the light absorbing layer ST20.

The light absorbing layer 33 may include a non-silicon semiconductor material. For instance, the light absorbing layer 33 may include group I-III-IV compounds. For instance, the light absorbing layer 33 may include Cu-In-Ga-Se (CIGS) compounds, Cu-In-Se (CIS) compounds, or Cu-Ga-Se (CGS) compounds.

The light absorbing layer 33 may have an energy bandgap in the range of about 1eV to about 1.8eV. However, the embodiment is not limited thereto, and the light absorbing layer 33 may have various energy bandgaps.

The light absorbing layer 33 can be formed through various schemes, such as an evaporation scheme or a sputtering scheme.

As an example, a method for forming the CIGS light absorbing layer 33 through the evaporation scheme or the sputtering scheme will be described below.

According to the evaporation scheme, the CIGS light absorbing layer 33 is formed by simultaneously or separately evaporating Cu, In, Ga and Se.

According to the sputtering scheme, a metallic precursor layer is formed and then the selenization process is performed to form the CIGS light absorbing layer 33. That is, according to the sputtering scheme, the metallic precursor layer including Cu, In and Ga is formed by using a Cu target, an In target and a Ga target. Then, the selenization process is performed to form the CIGS light absorbing layer 33. Otherwise, the sputtering process and the selenization process are simultaneously performed to form the CIGS light absorbing layer 33.

Although the method for manufacturing the CIGS light absorbing layer 33 has been described above, various types of light absorbing layers 33 can be formed by varying the target and the evaporation material according to the source materials.

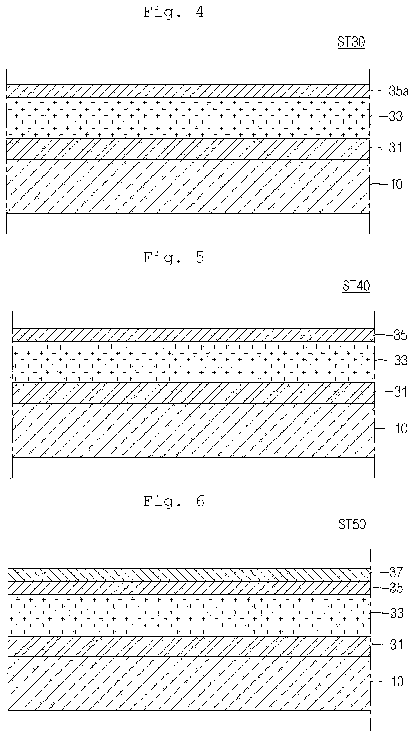

Then, as shown in FIG. 4, a buffer layer 35a is formed on the light absorbing layer 33 in the steps of forming the buffer layer ST30.

The buffer layer 35a is provided to attenuate the difference in lattice constant and energy bandgap with respect to a second electrode 29. The buffer layer 35a includes ZnS. The buffer layer 35a can be formed through the chemical bath deposition (CBD).

As an example not forming part of the invention, the method for forming the buffer layer 35a including CdS through the CBD will be described below in detail. The buffer layer 35a including CdS can be formed by dipping the light absorbing layer 33 in a solution to form the buffer layer, in which Cd²⁺ and S2- are excessively saturated, and then maintaining a predetermined reaction temperature for a predetermined time. For instance, the solution to form the buffer layer may include cadmium acetate or thiourea. In addition, a buffering agent or ammonia may be further added in the solution. In addition, the reaction temperature may be in the range of about 50 to about 100.

The oxygen content of the buffer layer 35a formed through the above process is approximate to 6% or more.

Then, as shown in FIG. 5, the annealing step ST40 is performed to reduce the oxygen content in the buffer layer 35a, thereby forming a buffer layer 35 having a reduced oxygen content (hereinafter, referred to as "annealed buffer layer".

According to the present embodiment, the buffer layer 35a is annealed through the rapid thermal annealing (RTA) process to reduce the oxygen content in the buffer layer 35a.

In this case, the annealing temperature is in the range of 250 to 400 . If the annealing temperature exceeds 400 , re-deposition and crack may occur so that the buffer layer 35a may be damaged. If the annealing temperature is less than 250 , the oxygen content may be rarely reduced through the annealing process. That is, the annealing temperature is determined in such a manner that the oxygen content in the buffer layer 35a can be property reduce without causing the damage to the buffer layer 35a.

In addition, the annealing step may be performed in the atmosphere suitable for reducing the oxygen content in the buffer layer 35a. For instance, the annealing step may be performed in the vacuum atmosphere or the hydrogen atmosphere.

The annealed buffer layer 35 formed through the annealing step ST40 has the oxygen content in the range of 2 at% to 5 at%.

After that, as shown in FIG. 6, a high-resistance buffer layer 37 is formed on the annealed buffer layer 35 in the step of forming the high-resistance buffer layer ST50.

The high-resistance buffer layer 37 is provided to prevent the buffer layer 35 from being damaged when the second electrode layer 39 is formed. The high-resistance buffer layer 37 is formed by depositing ZnO. However, the embodiment is not limited thereto, but the high-resistance buffer layer 37 can be formed through various schemes.

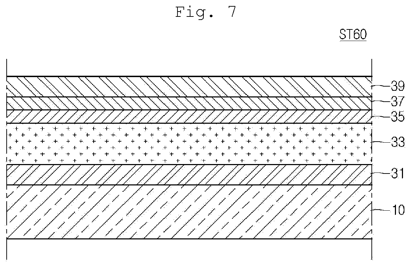

Then, as shown in FIG. 7, the second electrode layer 39 (or window layer) is formed on the buffer layer, in detail, on the high-resistance buffer layer 37 in the step of forming the second electrode ST60.

The second electrode layer 39 is transparent so the light can be incident into the second electrode layer 39. The second electrode may be formed by using a transmissive conductive material serving as an electrode. In addition, the second electrode layer 39 has the characteristic of an N type semiconductor, so the second electrode layer 39 may form an N type semiconductor layer together with the buffer layer 35 and may form a PN junction together with the light absorbing layer 33 serving as a P type semiconductor layer.

To this end, for instance, the second electrode layer 39 may be formed by using a transparent conductive material, such as aluminum-doped zinc oxide (AZO), fluorine-doped tin oxide (FTO), gallium-doped zinc oxide (GZO), or boron-doped zinc oxide (BZO). The second electrode layer 39 can be formed through various methods.

The annealed buffer layer 35 includes ZnS and has the oxygen content in the range of 2 at% to 5 at%.

Since the oxygen content in the annealed buffer layer 35 is equal to or less than 5 at%, the photoelectric conversion efficiency of the solar cell can be improved. If the oxygen content in the annealed buffer layer 35 exceeds 5 at%, oxygen in the annealed buffer layer 35 may serve as an electron trap, lowering the photoelectric conversion efficiency. Thus, according to the embodiment, the oxygen content in the annealed buffer layer 35 is maintained within 5 at%, thereby improving the photoelectric conversion efficiency.

In addition, since the oxygen content in the annealed buffer layer 35 is equal to or higher than 2 at%, the recombination at the interfacial surface between the annealed buffer layer 35 and the light absorbing layer 33 can be effectively prevented. In general, oxide (for instance, sodium oxide) prevents the recombination at the interfacial surface between the annealed buffer layer 35 and the light absorbing layer 33. If the oxygen content in the annealed buffer layer 35 is excessively lowered, the amount of the oxide may be reduced so that the recombination may occur. Thus, according to the embodiment, the oxygen content in the annealed buffer layer 35 is maintained not less than 2 at%, thereby preventing the recombination at the interfacial surface of the light absorbing layer 33.

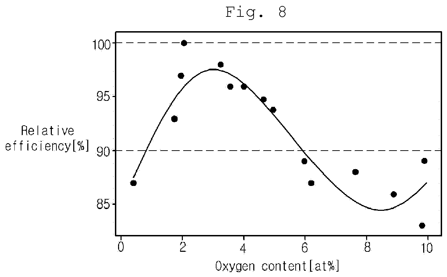

FIG. 8 is a graph showing the relative efficiency of the solar cell as a function of the oxygen content in the buffer layer. Referring to FIG. 8, if the oxygen content in the buffer layer 35 is less than 2 at% or exceeds 5 at%, the relative efficiency of the solar cell is less than 90%. In addition, if the oxygen content in the buffer layer 35 is maintained in the range of 2 at% to 5 at%, the relative efficiency of the solar cell is more than 90%. That is, according to the embodiment, the efficiency of the solar cell can be improved by controlling the oxygen content in the buffer layer 35.

Any reference in this specification to "one embodiment," "an embodiment," "example embodiment," etc., means that a particular feature, structure, or characteristic described in connection with the embodiment is included in at least one embodiment of the invention. The appearances of such phrases in various places in the specification are not necessarily all referring to the same embodiment. Further, when a particular feature, structure, or characteristic is described in connection with any embodiment, it is submitted that it is within the purview of one skilled in the art to effect such feature, structure, or characteristic in connection with other ones of the embodiments.

## Claims

1. A method for manufacturing a solar cell, the method comprising:
(ST10) forming a first electrode layer (31) on a substrate (10);
(ST20) forming a light absorbing layer (33) on the first electrode layer (31);
(ST30) forming a buffer layer (35a) on the light absorbing layer (33);
(ST40) annealing the buffer layer (35) to reduce an oxygen content in the buffer layer (35);
(ST50) forming a high-resistance buffer layer (37) on the annealed buffer layer (35), the high-resistance buffer layer (37) comprising ZnO, and
(ST60) forming a second electrode layer (39) on the high-resistance buffer layer (37),
**characterized in that**:
the buffer layer (35) has an oxygen content in a range of 2 at% to 5 at% after the annealing;
the buffer layer (35) has an oxygen content of 6 at% or more before the annealing;
wherein the buffer layer (35) includes ZnS;
wherein the light absorbing layer (33) includes group I-III-IV compounds;
wherein an annealing temperature is in a range of 250°C to 400 °C; and
wherein the step of annealing (ST40) includes a rapid thermal annealing (RTA).

2. The method of claim 1, wherein the annealing (ST40) is performed in a vacuum atmosphere or a hydrogen atmosphere.

3. The method of claim 1, wherein the buffer layer (35) is formed through a chemical bath deposition (CBD) scheme.

## Patentansprüche

1. Verfahren zur Herstellung einer Solarzelle, wobei das Verfahren umfasst:
(ST10) Bilden einer ersten Elektrodenschicht (31) auf einem Substrat (10);
(ST20) Bilden einer lichtabsorbierenden Schicht (33) auf der ersten Elektrodenschicht (31);
(ST30) Bilden einer Pufferschicht (35a) auf der lichtabsorbierenden Schicht (33);
(ST40) Tempern der Pufferschicht (35) zum Verringern eines Sauerstoffgehalts in der Pufferschicht (35) ;
(ST50) Bilden einer hochresistenten Pufferschicht (37) auf der getemperten Pufferschicht (35), wobei die hochresistente Pufferschicht (37) ZnO umfasst, und
(ST60) Bilden einer zweiten Elektrodenschicht (39) auf der hochresistenten Pufferschicht (37),
**dadurch gekennzeichnet, dass**:
die Pufferschicht (35) einen Sauerstoffgehalt in einem Bereich von 2 At-% bis 5 At-% nach dem Tempern aufweist;
die Pufferschicht (35) einen Sauerstoffgehalt von 6 At-% oder mehr vor dem Tempern aufweist;
wobei die Pufferschicht (35) ZnS beinhaltet;
wobei die lichtabsorbierende Schicht (33) Gruppe I-III-IV Verbindungen beinhaltet;
wobei eine Temper-Temperatur in einem Bereich von 250 °C bis 400 °C ist; und
wobei ein Schritt des Temperns (ST40) ein Kurzzeittempern (RTA) beinhaltet.

2. Verfahren nach Anspruch 1, wobei das Tempern (ST40) in einer Vakuum-Atmosphäre oder einer Wasserstoff-Atmosphäre durchgeführt wird.

3. Verfahren nach Anspruch 1, wobei die Pufferschicht (35) durch eine chemische Badabscheidung (CBD) gebildet wird.

## Revendications

1. Procédé de fabrication d'une cellule solaire, le procédé comprenant :
(ST10) la formation d'une première couche d'électrode (31) sur un substrat (10) ;
(ST20) la formation d'une couche d'absorption de lumière (33) sur la première couche d'électrode (31) ;
(ST30) la formation d'une couche tampon (35a) sur la couche d'absorption de lumière (33) ;
(ST40) le recuit de la couche tampon (35) pour réduire une teneur en oxygène dans la couche tampon (35) ;
(ST50) la formation d'une couche tampon à haute résistance (37) sur la couche tampon recuite (35), la couche tampon à haute résistance (37) comprenant du ZnO, et
(ST60) la formation d'une seconde couche d'électrode (39) sur la couche tampon à haute résistance (37),
**caractérisé en ce que** :
la couche tampon (35) possède une teneur en oxygène dans une plage de 2 % atomique à 5 % atomique après le recuit ;
la couche tampon (35) possède une teneur en oxygène de 6 % atomique ou plus avant le recuit ;
dans lequel la couche tampon (35) inclut du ZnS ;
dans lequel la couche d'absorption de lumière (33) inclut des composés des groupes I-III-IV ;
dans lequel une température de recuit est dans une plage de 250 °C à 400 °C ; et
dans lequel l'étape de recuit (ST40) inclut un recuit thermique rapide (RTA).

2. Procédé selon la revendication 1, dans lequel le recuit (ST40) est réalisé sous une atmosphère sous vide ou une atmosphère d'hydrogène.

3. Procédé selon la revendication 1, dans lequel la couche tampon (35) est formée au travers d'un mécanisme de dépôt par bain chimique (CBD).
